# EUROPEAN PATENT SPECIFICATION

(11) **EP 3 683 333 B1**
(45) Date of publication and mention of the grant of the patent: **28.06.2023**
(21) Application number: 19812618.7
(22) Date of filing: 16.05.2019
(51) Int. Cl.: C23C 14/04, B41F 5/04, B41F 9/00, B41F 17/10, B41M 1/02, B41M 1/10, B41M 1/28, B41M 1/30, B65H 20/00, C23C 14/02, C23C 14/14, C23C 14/24, C23C 14/56

(54) **WINDING-TYPE FILM DEPOSITION DEVICE AND WINDING-TYPE FILM DEPOSITION METHOD**
AUFWICKELFILMABSCHEIDUNGSVORRICHTUNG UND AUFWICKELFILMABSCHEIDUNGSVERFAHREN
DISPOSITIF DE DÉPÔT DE FILM DE TYPE À ENROULEMENT ET PROCÉDÉ DE DÉPÔT DE FILM DE TYPE À ENROULEMENT

(30) Priority: 31.05.2018 JP 2018104675
(43) Date of publication of application: 22.07.2020
(73) Proprietor: ULVAC, Inc., Chigasaki-shi, Kanagawa 253-8543 (JP)
(72) Inventor: SAKAMOTO, Junichi, Chigasaki-shi, Kanagawa 253-8543 (JP); SAITO, Kazuya, Chigasaki-shi, Kanagawa 253-8543 (JP); KIYOTA, Junya, Chigasaki-shi, Kanagawa 253-8543 (JP); TAKEI, Masaki, Chigasaki-shi, Kanagawa 253-8543 (JP); YOKOYAMA, Akihiro, Chigasaki-shi, Kanagawa 253-8543 (JP)
(74) Representative: Markfort, Iris-Anne Lucie
(86) International application number: PCT/JP2019/019504
(87) International publication number: WO 2019/230421

(56) References cited:
- WO-A1-97/38797
- WO-A1-2008/018297
- CN-A- 101 880 856
- JP-A- 2000 508 579
- JP-A- 2006 225 710
- JP-A- 2011 089 160
- JP-A- 2011 089 160
- JP-A- 2014 107 148
- JP-A- 2014 171 999
- JP-A- 2014 171 999
- US-A- 4 911 995

## Description

### Technical Field

The present invention relates to a roll-to-roll deposition apparatus and a roll-to-roll deposition method as a high-speed film deposition technology for a low-melting-point metal.

### Background Art

While paying out a film wound around a payout roller, an apparatus deposits metal on the film and then takes up the film through a take-up roller as a type of roll-to-roll deposition apparatus.

In the roll-to-roll deposition apparatus of this type, a metal deposition source is disposed on the way between the payout roller and the take-up roller, facing the film (e.g., see Patent Literature 1). When metal evaporating from the metal deposition source adheres to the film, the phase of the metal changes from gas to solid on the film, and the solid-state metal layer is formed on the film.

### Citation List

### Patent Literature

Patent Literature 1: WO2008/018297
Patent Literature 2: JP2011 089160 A
Patent Literature 3: WO97/38797 A1

Patent Literature 2 discloses a vacuum chamber, and a pass box for collecting and introducing various members between the vacuum chamber and itself. A base material reel with a base film wound around it, a product reel with a lithium laminate film wound around it, a rotary roll for guiding the base film, a raw material crucible in which raw materials such as lithium are put in, and a shield plate having an opening are arranged in the vacuum chamber. The shield plate is a specified member formed of lithium or the like. Particles of the evaporated lithium or the like are deposited on the base film and the shield plate. During maintenance, the shield plate is replaced with a new one, and the shield plate with lithium or the like being deposited thereon is heated and melted, and is reused.

Patent Literature 3 discloses a device for the application of a coating composition on a travelling web comprising a transfer roll, a support roll cooperating with the transfer roll, the travelling web being fed in a nip between said rolls, further comprising a gravure roll intended for the transfer of an adapted quantity of the coating composition onto the transfer roll, and means for passing of the web through said nip, characterized by blade means for the removal of excess of coating composition from the gravure roll, said blade means being arranged in trailing position in relation to the moving surface of the gravure roll.

### Disclosure of Invention

### Technical Problem

However, if a metal layer is directly vapor-deposited on a travelling film, the film is susceptible to heat damage due to the latent heat. This latent heat becomes larger as the thickness of the metal layer vapor-deposited on the film becomes larger. Thus, the film becomes more susceptible to heat damage as the thickness of the film becomes larger.

In view of the above-mentioned circumstances, it is an object of the present invention to provide a roll-to-roll deposition apparatus and a roll-to-roll deposition method, by which a metal layer can be deposited as a film while reducing heat damage to the film.

### Solution to Problem

In order to accomplish the above-mentioned object, a roll-to-roll deposition apparatus according to an embodiment of the present invention includes the features of claim 1, namely a vacuum chamber, a film travel mechanism, a lithium source, a first, second and third roller, a vapor deposition container and a temperature control mechanism.

The vacuum chamber is capable of maintaining a reduced-pressure state.

The film travel mechanism is capable of causing a film to travel inside the vacuum chamber.

The lithium source is capable of evaporating lithium inside the vacuum chamber.

The first roller is disposed between a deposition surface of the film and the lithium source. The first roller has a transfer pattern that receives the lithium evaporated from the lithium source. The first roller transfers a pattern of a lithium layer corresponding to the transfer pattern to the deposition surface while rotating.

With such a roll-to-roll deposition apparatus, the molten lithium is received by the first roller having the transfer pattern, and the pattern of the lithium layer is indirectly transferred from the first roller to the deposition surface of the film. That is, the lithium layer is patterned onto the deposition surface of the film by vacuum deposition and application via the first roller. With this, heat damage to the film is reduced.

In the roll-to-roll deposition apparatus according to the invention, the lithium source further includes a third roller, a vapor deposition container, and optionally a doctor blade. The third roller faces the first roller. The vapor deposition container stores the lithium and is disposed such that the lithium is vapor-deposited on the third roller. The molten surface of the lithium is held in contact with the third roller. The optional doctor blade controls a thickness of the lithium supplied from the vapor deposition container to the third roller.

With such a roll-to-roll deposition apparatus, the thickness of the lithium supplied to the first roller from the vapor deposition container is more reliably controlled by the doctor blade and the third roller.

In the roll-to-roll deposition apparatus, the lithium source may further include a fourth roller, wherein the vapor deposition container is disposed such that the lithium is deposited on the fourth roller. The fourth roller faces the third roller.

With such a roll-to-roll deposition apparatus, the thickness of the lithium supplied to the first roller from the vapor deposition container is more reliably controlled by the third roller and the fourth roller. Further, due to the presence of the fourth roller, heat damage to the film is further reduced.

The roll-to-roll deposition apparatus may further include a pretreatment mechanism that cleans the deposition surface of the film, the pretreatment mechanism being placed upstream from the first roller.

With such a roll-to-roll deposition apparatus, the deposition surface of the film is cleaned before the pattern of the lithium layer is transferred from the first roller to the deposition surface of the film. With this, the adhesion force between the lithium layer and the film increases.

The roll-to-roll deposition apparatus may further include a protection layer-forming mechanism that forms a protection layer on a surface of the lithium layer, the protection layer-forming mechanism being placed downstream from the first roller.

With such a roll-to-roll deposition apparatus, the lithium layer is protected by the protection layer after the pattern of the lithium layer is transferred from the first roller to the deposition surface of the film.

The roll-to-roll deposition apparatus may further include a separator by which the protection layer-forming mechanism is isolated inside the vacuum chamber.

With such a roll-to-roll deposition apparatus, the protection layer-forming mechanism is isolated by the separator, and ingredients of the protection layer are barely mixed into the lithium layer.

Further, in order to accomplish the above-mentioned object, a roll-to-roll deposition method according to an embodiment of the present invention including the features of claim 7 causing a film to travel between a first roller and a second roller inside a vacuum chamber capable of maintaining a reduced-pressure state. Evaporated lithium is supplied from a vapor deposition container to a third roller, the vapor deposition container being disposed inside the vacuum chamber and storing the lithium, maintaining the lithium adhered to the third roller in a melting state by a temperature control mechanism for the third roller, supplying the lithium in the melting state on the third roller to the first roller on which a transfer pattern is formed. A pattern of a lithium layer corresponding to the transfer pattern is held in contact with a deposition surface of the film to transfer the pattern of the lithium layer to the deposition surface while rotating the first roller.

With such a roll-to-roll deposition method, the vapor-deposited lithium is supplied to the first roller having the transfer pattern and the pattern of the lithium layer is indirectly transferred to the deposition surface of the film from the first roller. That is, the lithium layer is patterned on the deposition surface of the film by vacuum deposition and application. With this, heat damage to the film is reduced.

### Advantageous Effects of Invention

As described above, in accordance with the present invention, a metal layer can be deposited as a film while reducing heat damage to the film.

### Brief Description of Drawings

[Fig. 1] A schematic structural diagram of a roll-to-roll deposition apparatus according to a first embodiment.
[Fig. 2] A schematic flowchart showing a roll-to-roll deposition method according to the first embodiment.
[Fig. 3] A schematic structural diagram showing an operation of the roll-to-roll deposition apparatus according to the first embodiment.
[Fig. 4] A schematic structural diagram of a roll-to-roll deposition apparatus according to a second embodiment.
[Fig. 5] A schematic structural diagram of a roll-to-roll deposition apparatus according to an alternative embodiment.
[Fig. 6] A schematic structural diagram showing an operation of the roll-to-roll deposition apparatus according to the embodiment of figure 5.
[Fig. 7] A schematic structural diagram of a part of a roll-to-roll deposition apparatus according to an alternative embodiment.

### Mode(s) for Carrying Out the Invention

Hereinafter, embodiments of the present invention will be described with reference to the drawings. Some of the figures have X-, Y-, and Z-axis coordinates.

### [First Embodiment]

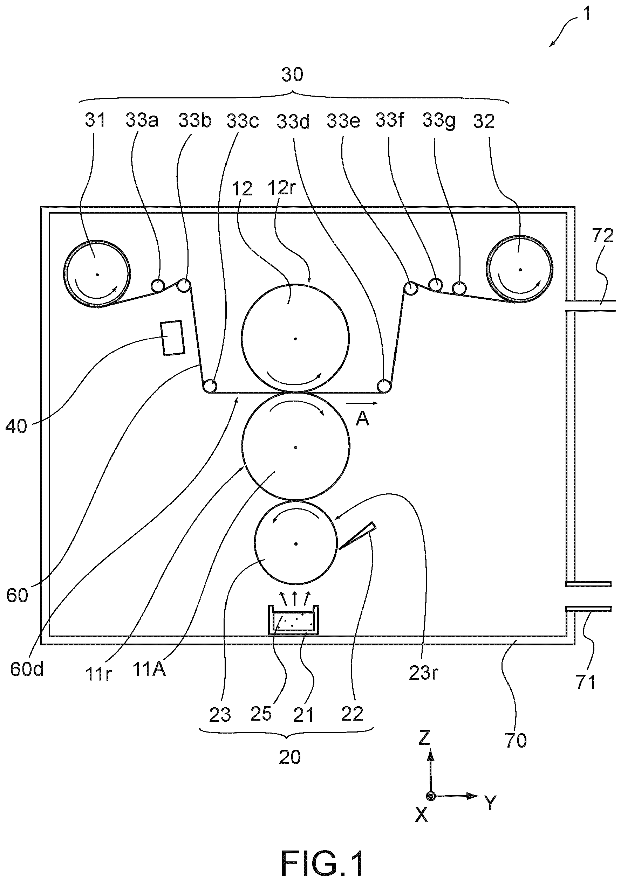

Fig. 1 is a schematic structural diagram of a roll-to-roll deposition apparatus according to a first embodiment.

A roll-to-roll deposition apparatus 1 shown in Fig. 1 is a roll-to-roll deposition apparatus capable of coating a film 60 with a metal layer (e.g., lithium layer) while causing the film 60 to travel. The roll-to-roll deposition apparatus 1 includes a first roller 11A, a lithium source 20, a film travel mechanism 30, and a vacuum chamber 70. In addition, the roll-to-roll deposition apparatus 1 includes a second roller 12, a pretreatment mechanism 40, a gas discharge mechanism 71, and a gas supply mechanism 72.

The first roller 11A is a tubular member containing metal such as stainless steel, iron, and aluminum. The first roller 11A is disposed between the film 60 and the lithium source 20. The first roller 11A faces a deposition surface 60d of the film 60. For example, a roller surface 11r of the first roller 11A is held in contact with the deposition surface 60d of the film 60. Further, a transfer pattern is formed on the roller surface 11r. The transfer pattern is, for example, a convex pattern such as a bank-shaped pattern and a hill-shaped pattern. Therefore, the first roller 11A can also be called plate cylinder in relief printing.

The first roller 11A is rotatable about its center axis. For example, a rotary drive mechanism that rotationally drives the first roller 11A may be provided outside the roll-to-roll deposition apparatus 1. Alternatively, the first roller 11A itself may include the rotary drive mechanism.

For example, with the film 60 traveling in an arrow-A direction, the first roller 11A made to face the film 60 is rotated in the clockwise direction. At this time, the movement velocity (tangential velocity) of the roller surface 11r is set to be equal to the travel velocity of the film 60, for example. With this, after a lithium pattern is formed on the roller surface 11r, this lithium pattern is transferred to the deposition surface 60d of the film 60 without position shift. Alternatively, the velocity at which this roller surface 11r moves may be set to be different from the travel velocity of the film 60 (lower or higher velocity). The film thickness or the like of the lithium 25 may be changed by utilizing this velocity difference.

Further, in this embodiment, a temperature control mechanism such as a temperature control medium circulation system is provided inside the first roller 11A. With this temperature control mechanism, control is performed as appropriate such that, for example, the temperature of the roller surface 11r can be equal to or higher than the melting point of lithium.

The second roller (back-up roller) 12 is a tubular member containing metal such as stainless steel, iron, and aluminum. The second roller 12 faces the first roller 11A with the film 60 provided between the second roller and the first roller 11A. A roller surface 12r of the second roller 12 is held in contact with a back surface of the film 60 (surface opposite to the deposition surface 60d). The transfer pattern is not formed on the roller surface 12r.

The second roller 12 is rotatable about its center axis. For example, the second roller 12 held in contact with the film 60 is rotated in the counter-clockwise direction due to the travel of the film 60. Alternatively, a rotary drive mechanism that rotationally drives the second roller 12 may be provided outside the roll-to-roll deposition apparatus 1. Alternatively, the second roller 12 itself may include the rotary drive mechanism. In this case, the second roller 12 is rotated by the rotary drive mechanism in the counter-clockwise direction.

Further, in this embodiment, a temperature control mechanism such as a temperature control medium circulation system may be provided inside the second roller 12. With this temperature control mechanism, control is performed as appropriate such that, for example, the temperature of the roller surface 12r can be smaller than the melting point of lithium.

The lithium source 20 includes a vapor deposition container 21, a doctor blade 22, and a third roller 23. The lithium source 20 is disposed facing the first roller 11A.

The vapor deposition container 21 stores molten lithium (Li) 25 in the form of a bulk, wire, or powder, for example. For example, during operation of the roll-to-roll deposition apparatus 1, the lithium 25 is heated and evaporated in the vapor deposition container 21 by using a technique such as resistance heating, induction heating, and electron beam heating. The film thickness of the lithium 25 may be adjusted by controlling the amount of evaporation by using those techniques.

The heating temperature of the lithium 25 is not particularly limited. Typically, the heating temperature of the lithium 25 is set to a temperature (e.g., 180°C to 800°C) equal to or higher than the melting point of the lithium. In a case where a natural film (Li₂O or the like) is formed on the surface of the lithium, a target heating temperature is set such that only the lithium 25 can be evaporated (or distilled).

The third roller 23 is a tubular member, and is a so-called anilox roller. The first roller 11A is located between the third roller 23 and the second roller 12. For example, the third roller 23, the first roller 11A, and the second roller 12 are arranged in the stated order from the top to the bottom of the roll-to-roll deposition apparatus 1. The third roller 23 faces the first roller 11A. A roller surface 23r of the third roller 23 is formed of a layer (e.g., chromium (Cr) layer or ceramic layer) having a plurality of holes, for example.

The roller surface 23r of the third roller 23 is held in contact with the roller surface 11r of the first roller 11A. In addition, in the example of Fig. 1, the vapor deposition container 21 is disposed below the third roller 23 and causes vapor of a vapor deposition substance to adhere to the third roller 23 that the vapor deposition container 21 faces. That is, the vapor deposition container 21 is disposed such that the evaporated lithium 25 adheres to a part of the roller surface 23r.

The third roller 23 is rotatable about its center axis. For example, the third roller 23 held in contact with the first roller 11A is rotated in the counter-clockwise direction by rotation of the first roller 11A. Alternatively, a rotary drive mechanism that rotationally drives the third roller 23 may be provided outside the roll-to-roll deposition apparatus 1. Alternatively, the third roller 23 itself may include the rotary drive mechanism. In this case, the third roller 23 is rotated by the rotary drive mechanism in the counter-clockwise direction.

Further, in this embodiment, a distance control mechanism that changes a relative distance between the third roller 23 and the vapor deposition container 21 may be provided outside the roll-to-roll deposition apparatus 1. With this distance control mechanism, the amount of lithium 25 that adheres to the roller surface 23r can be changed.

When the third roller 23 rotates with the lithium 25 vapor-deposited on the third roller 23, the lithium 25 in the vapor deposition container 21 is upwardly moved via the roller surface 23r. With this, the vapor-deposited lithium 25 is supplied from the vapor deposition container 21 to the entire area of the roller surface 23r of the third roller 23. Further, in the roll-to-roll deposition apparatus 1, the doctor blade 22 is provided near the roller surface 23r of the third roller 23.

Due to the provision of the doctor blade 22, the thickness of the lithium 25 on the roller surface 23r is accurately adjusted. For example, the thickness of the lithium 25 on the roller surface 23r is adjusted to be substantially the same. With this, the supply amount of lithium 25 is constant on the first roller 11A supplied with the lithium 25 from the third roller 23.

Then, the lithium 25 on the roller surface 23r extends over the roller surface 11r of the first roller 11A held in contact with the lithium 25 on the roller surface 23r. In this manner, a constant amount of lithium 25 is supplied from the vapor deposition container 21 to the roller surface 11r of the first roller 11A via the third roller 23.

In this case, the supply amount of lithium 25 supplied to the roller surface 23r by the doctor blade 22 is constant. Therefore, the supply amount of lithium 25 supplied to the roller surface 11r of the first roller 11A is also constant. With this, the thickness of the lithium 25 on the roller surface 11r is the same in the entire circumference.

Further, in this embodiment, a temperature control mechanism such as a temperature control medium circulation system is provided inside the third roller 23. With this temperature control mechanism, control is performed as appropriate such that, for example, the temperature of the roller surface 23r can be equal to or higher than the melting point of lithium.

With this, adhesion of the evaporated lithium 25 to the roller surface 23r from the vapor deposition container 21 and supply of the molten lithium 25 to the first roller 11A in the third roller 23 are realized.

The film travel mechanism 30 includes a payout roller 31, a take-up roller 32, and guide rollers 33a, 33b, 33c, 33d, 33e, 33f, and 33g. A rotary drive mechanism that rotationally drives the payout roller 31 and the take-up roller 32 is provided outside the roll-to-roll deposition apparatus 1. Alternatively, each of the payout roller 31 and the take-up roller 32 may include the rotary drive mechanism.

Further, in this embodiment, temperature control mechanisms such as temperature control medium circulation systems may be provided inside the guide rollers 33a, 33b, 33c, 33d, 33e, 33f, 33g.

The film 60 is placed in the roll-to-roll deposition apparatus 1, nipped between the first roller 11A and the second roller 12. The deposition surface 60d of the film 60 faces the first roller 11A. The film 60 is wound around the payout roller 31 in advance and paid out from the payout roller 31.

The film 60 paid out from the payout roller 31 is traveling while being supported by the guide rollers 33a, 33b, and 33c, and is moved between the first roller 11A and the second roller 12 while changing the travel direction at each of the guide rollers 33a, 33b, and 33c.

In addition, the film 60 is traveling while being supported by the guide rollers 33d, 33e, 33f, and 33g, and continuously taken up by the take-up roller 32 while changing the travel direction at each of the guide rollers 33d, 33e, 33f, and 33g.

The film 60 is a long film cut at a predetermined width. The film 60 includes at least any of copper, aluminum, nickel, stainless steel, and resin. Regarding the resin, an OPP (oriented polypropylene) film, a PET (polyethylene terephthalate) film, or a PPS (polyphenylene sulfide) film is used, for example.

The pretreatment mechanism 40 is placed upstream from the first roller 11A. The pretreatment mechanism 40 cleans the deposition surface 60d of the film 60. For example, the pretreatment mechanism 40 is capable of generating plasma of inert gas (Ar, He, etc.), nitrogen (N₂), oxygen (O₂), and the like. When the deposition surface 60d of the film 60 is exposed to this plasma, an oil film, a natural oxidation film, and the like adhering to the deposition surface 60d are removed. With this, the adhesion force of the lithium layer formed on the deposition surface 60d increases.

The first roller 11A, the second roller 12, the lithium source 20, the film travel mechanism 30, the pretreatment mechanism 40, and the film 60 described above are stored in the vacuum chamber 70. The vacuum chamber 70 is capable of maintaining a reduced-pressure state. For example, the interior of the vacuum chamber 70 is maintained at a predetermined degree of vacuum at which vapor deposition of lithium is possible by the gas discharge mechanism 71 connected to a vacuum pumping system (not shown) such as a vacuum pump. With this, an environment where the dew point of lithium is lower than -30°C (more favorably, lower than -50°C) is easily formed, and the melting state of lithium can be stably kept inside the vacuum chamber 70. Reaction of lithium having a much higher reactivity is suppressed.

In evacuation of the vacuum chamber 70, the gas supply mechanism 72 may evacuate the vacuum chamber 70 after supplying at least any of gases such as dry air, inert gas (Ar, He, etc.), carbon dioxide (CO₂), nitrogen, and the like as replacement gas. By introducing these gases into the vacuum chamber 70, reaction of lithium having a high reactivity is suppressed.

Further, in this embodiment, at least any of indium (In), zinc (Zn), tin (Sn), gallium (Ga), bismuth (Bi), natrium (Na), kalium (K), and alloy having a melting point of 400°C or less may be stored in the vapor deposition container 21 in addition to lithium.

The vapor deposition container 21 is made of an austenitic stainless steel, for example.

### [Operation of Roll-to-Roll Deposition Apparatus]

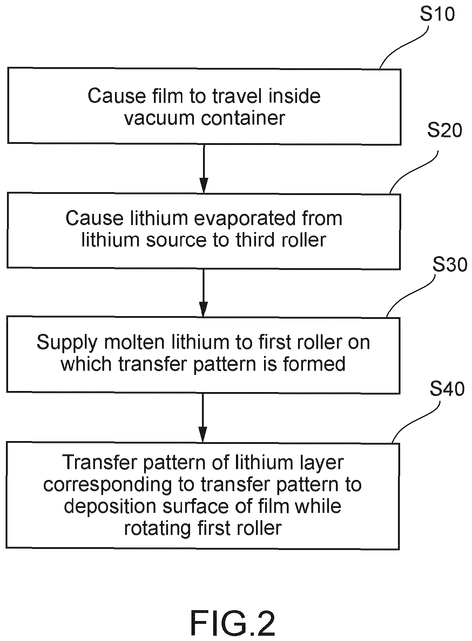

Fig. 2 is a schematic flowchart showing a roll-to-roll deposition method according to the first embodiment.

In the roll-to-roll deposition method according to the first embodiment, the film travel mechanism 30 causes the film 60 to travel inside the vacuum chamber 70 capable of maintaining a reduced-pressure state, for example (Step S10).

Next, the evaporated lithium 25 adheres to the third roller 23 from the lithium source 20 (vapor deposition container 21) (Step S20). The temperature control mechanism of the third roller 23 maintains the lithium 25 adhering to the third roller 23 in the melting state.

Next, the lithium 25 in the melting state on the third roller 23 is supplied to the first roller 11A on which the transfer pattern is formed (Step S30).

After that, the pattern of the lithium layer corresponding to the transfer pattern is transferred to the deposition surface by holding the pattern of the lithium layer corresponding to the transfer pattern in contact with the deposition surface 60d of the film 60 while rotating the first roller 11A (Step S40).

With such a roll-to-roll deposition method, the evaporated lithium 25 is supplied to the first roller 11A having the transfer pattern via the third roller 23, and the pattern of the lithium layer is transferred from the first roller 11A to the deposition surface 60d of the film 60.

That is, the lithium 25 (molten metal) is not directly vapor-deposited on the first roller 11A from the vapor deposition container 21 (tub). The lithium 25 (molten metal) is vapor-deposited on the third roller 23 once. Then, the lithium 25 (molten metal) is applied to the deposition surface 60d while maintaining the melting state through the temperature control mechanism of the third roller 23.

The lithium layer is patterned onto the deposition surface 60d of the film 60 by vacuum deposition and application. With this, heat damage to the film 60 is reduced.

A specific operation of the roll-to-roll deposition apparatus 1 will be described.

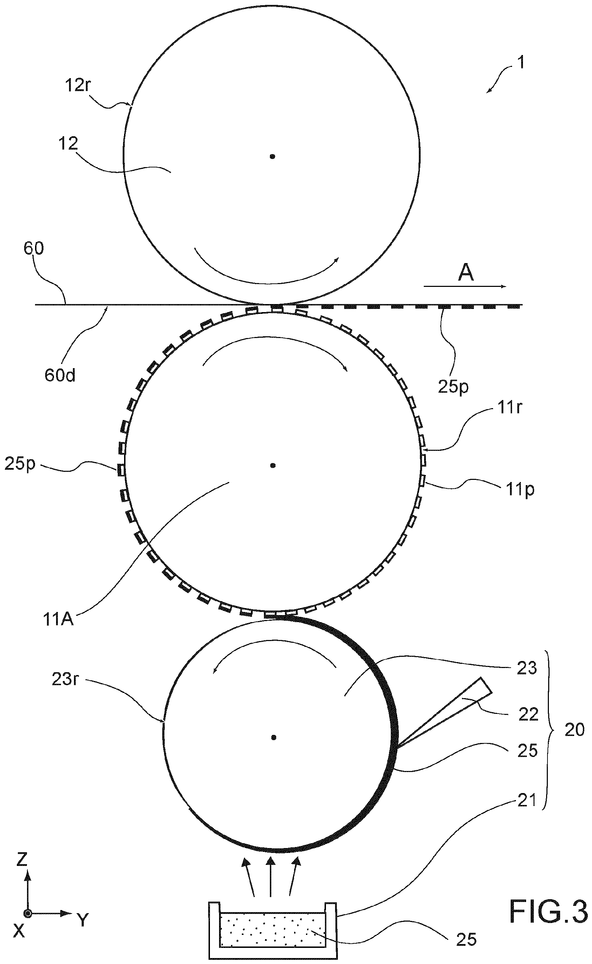

Fig. 3 is a schematic structural diagram showing an operation of the roll-to-roll deposition apparatus according to the first embodiment.

As shown in Fig. 3, the film 60 travels between the first roller 11A and the second roller 12 in the arrow-A direction. Here, a convex transfer pattern 11p is formed on the roller surface 11r of the first roller 11A. The material of the transfer pattern 11p includes, for example, an elastic material such as a rubber, an organic or inorganic resin, and the like. The reduced-pressure state is maintained inside the vacuum chamber 70. The inside of the vacuum chamber 70 is, for example, set to 1 × 10⁻³ Pa or less as a goal degree of vacuum of the vacuum pumping system (vacuum pump) of the gas discharging mechanism 71. At least any of gases such as the dry air, inert gas (Ar, He, etc.), carbon dioxide (CO₂), nitrogen, and the like may be supplied into the vacuum chamber 70. Further, the deposition surface 60d of the film 60 is subjected to pretreatment (cleaning) by the pretreatment mechanism 40.

Next, the liquid lithium 25 vapor-deposited on the third roller 23 from the vapor deposition container 21 is supplied onto the transfer pattern 11p of the first roller 11A.

For example, the vapor deposition container 21 is disposed below the third roller 23 such that the lithium 25 evaporated from the vapor deposition container 21 adheres to a part of the roller surface 23r of the third roller 23. In addition, the temperature of the roller surface 23r of the third roller 23 is adjusted to a lithium melting point (180°C) or more by the temperature control mechanism. With this, the lithium 25 vapor-deposited on the third roller 23 is supplied to the first roller 11A with the lithium 25 molten on the roller surface 23r (by the third roller 23 rotating in the counter-clockwise direction). Further, the thickness of the lithium 25 on the roller surface 23r is accurately evenly adjusted by the doctor blade 22.

Next, the first roller 11A is rotated in the clockwise direction with the rotation of the third roller 23. In addition, the first roller 11A is held in contact with the third roller 23. With this, the transfer pattern 11p of the first roller 11A gets wet with the molten lithium 25, and the roller surface 11r receives the molten lithium 25 from the roller surface 23r. That is, the molten lithium 25 is formed on the transfer pattern 11p, and a pattern 25p of the lithium 25 corresponding to the transfer pattern 11p is formed on the roller surface 11r.

Here, the temperature of the roller surface 11r of the first roller 11A is controlled by the temperature control mechanism to be equal to or higher than the melting point (180 °C) of lithium. With this, also when the first roller 11A is rotated and the roller surface 11r is thus separated from the third roller 23, the lithium 25 is kept wet in the melting state on the transfer pattern 11p.

The film 60 is traveling between the first roller 11A and the second roller 12 with the rotation of the first roller 11A and the second roller 12. Here, the first roller 11A is held in contact with the deposition surface 60d of the film 60. With this, the pattern 25p is also held in contact with the deposition surface 60d of the film 60, and the pattern 25p is transferred from the transfer pattern 11p to the deposition surface 60d of the film 60.

After that, regarding the pattern 25p of the lithium 25 on the deposition surface 60d, the pattern 25p of the lithium layer is formed on the deposition surface 60d of the film 60 by the temperature control mechanisms of the guide rollers 33a, 33b, 33c, 33d, 33e, 33f, 33g, natural cooling, and the like. The thickness of the lithium layer formed on the deposition surface 60d is, for example, 0.5 µm or more and 50 µm or less. Note that the pattern 25p of the lithium layer may be formed on both sides of the film 60.

In this manner, in this embodiment, the lithium 25 evaporated from the vapor deposition container 21 adheres to the roller surface 23r of the third roller 23 including the temperature control mechanism for keeping the melting state. After that, the molten lithium 25 is received by the first roller 11A having the transfer pattern 11p.

After that, the pattern 25p of the lithium layer is transferred from the first roller 11A to the deposition surface 60d of the film 60.

As described above, in this embodiment, the lithium 25 indirectly transfers to the deposition surface 60d from the vapor deposition container 21 via the first roller 11A and the third roller 23.

In this embodiment, the lithium 25 (pattern 25p) is not directly supplied to the deposition surface 60d of the film 60 while changing from the gas phase state to the solid phase state. The lithium 25 (pattern 25p) is indirectly supplied to the deposition surface 60d of the film 60 through the liquid phase state (while changing the gas phase state -> the liquid phase state -> the solid phase state). With this, the latent heat applied to the film 60 from lithium is reduced and heat damage to the film 60 is greatly reduced. For example, even if relatively thick pattern of the lithium layer, which has a thickness of 0.5 µm or more and 50 µm or less, is formed on the deposition surface 60d of the film 60, heat damage to the film 60 is smaller.

Further, in this embodiment, the first roller 11A is provided with the transfer pattern 11p, and the lithium pattern 25p is formed on the film 60 from the first roller 11A directly. With this, it is unnecessary to use a dedicated mask for forming the lithium pattern on the film 60. With this, regular maintenance work of exchanging a mask to which lithium has adhered. In addition, it is unnecessary to use a complicated mechanism for taking up and paying out the mask together with the film 60 and a complicated mechanism for positioning the mask.

Further, in this embodiment, the lithium layer is patterned onto the film 60 in a reduced-pressure atmosphere. With this, the melting state of lithium can be stably maintained inside the vapor deposition container 21, and an environment where reaction of lithium having a much higher reactivity is suppressed is easily formed. Further, also if the lithium layer is patterned onto the film 60 in an inert gas atmosphere, reaction of lithium having a high reactivity is suppressed.

Further, in this embodiment, the film 60 is nipped by the first roller 11A and the second roller 12 from upper and lower sides and the transfer pattern 11p is transferred to the film 60 while the film 60 is moved in a horizontal direction. With this, the pattern 25p immediately after transferring to the film 60 is barely displaced in an in-plane direction of the film 60.

### [Second Embodiment]

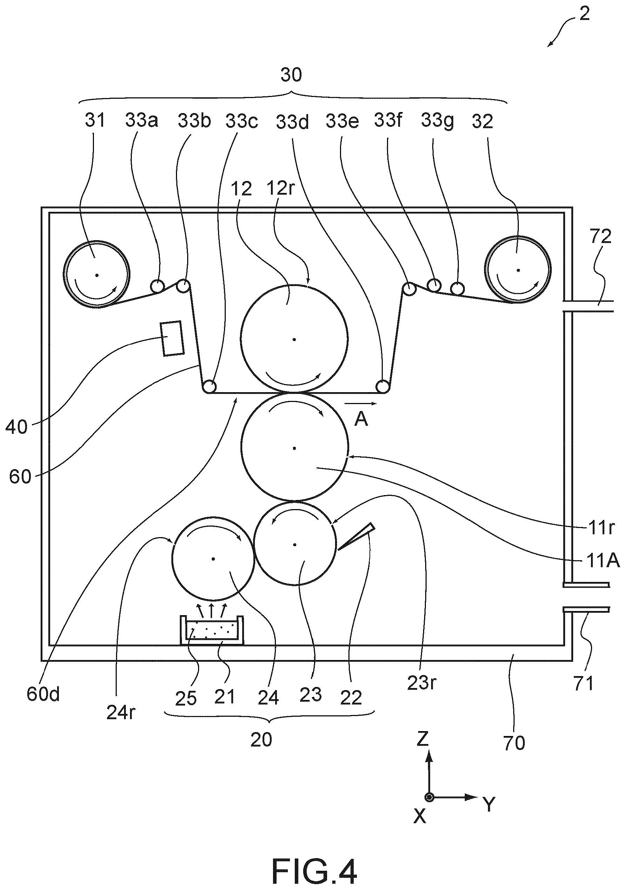

Fig. 4 is a schematic structural diagram of a roll-to-roll deposition apparatus according to a second embodiment.

In a roll-to-roll deposition apparatus 2 shown in Fig. 4, the lithium source 20 includes the vapor deposition container 21, the third roller 23, and a fourth roller 24 made to face the third roller 23. Although Fig. 4 illustrates the doctor blade 22 as the lithium source 20, the doctor blade 22 can be omitted depending on needs. In this case, the film thickness of the lithium 25 may be controlled by utilizing the distance (pressing force) and a rotation velocity difference between the third roller 23 and the fourth roller 24.

The fourth roller 24 is a tubular member, and is a so-called fountain roller. The third roller 23 is located between the fourth roller 24 and the first roller 11A. A well-known material resistant to heat is employed for a roller surface 24r of the fourth roller 24. The roller surface 24r of the fourth roller 24 is, for example, made of metal. The roller surface 24r of the fourth roller 24 is held in contact with the roller surface 23r of the third roller 23.

In addition, in the example of Fig. 4, the vapor deposition container 21 is disposed below the fourth roller 24 such that the lithium 25 evaporated from the vapor deposition container 21 adheres to a part of the roller surface 24r of the fourth roller 24 as in the third roller of the roll-to-roll deposition apparatus according to the first embodiment.

The fourth roller 24 is rotatable about its center axis. For example, the fourth roller 24 held in contact with the third roller 23 is rotated in the clockwise direction by rotation of the third roller 23. Alternatively, a rotary drive mechanism that rotationally drives the fourth roller 24 may be provided outside the roll-to-roll deposition apparatus 2. Alternatively, the fourth roller 24 itself may include the rotary drive mechanism. In this case, the fourth roller 24 is rotated by the rotary drive mechanism in the clockwise direction.

Further, in this embodiment, a distance control mechanism that changes a relative distance between the fourth roller 24 and the vapor deposition container 21 may be provided outside the roll-to-roll deposition apparatus 2. With this distance control mechanism, the amount of lithium 25 that adheres to the roller surface 24r of the fourth roller 24 can be changed.

When the fourth roller 24 is rotated with the lithium 25 vapor-deposited on the fourth roller 24, the lithium 25 in the vapor deposition container 21 is upwardly moved via the roller surface 24r. With this, the vapor-deposited lithium 25 is supplied from the vapor deposition container 21 to the entire area of the roller surface 24r of the fourth roller 24. In addition, the lithium 25 on the roller surface 24r extends over the roller surface 23r of the third roller 23 held in contact with the lithium 25 on the roller surface 24r.

In addition, the lithium 25 on the roller surface 23r extends over the roller surface 11r of the first roller 11A held in contact with the lithium 25 on the roller surface 23r. That is, the evaporated lithium 25 is supplied from the vapor deposition container 21 to the roller surface 11r of the first roller 11A via the fourth roller 24 and the third roller 23.

Here, the movement velocity of the roller surface 24r may be set to be different from the movement velocity of the roller surface 23r of the third roller 23 or may be set to be equal to the movement velocity of the roller surface 23r of the third roller 23. With this velocity control, the thickness of the lithium 25 on the roller surface 23r is accurately adjusted. For example, the thickness of the lithium 25 on the roller surface 23r is adjusted to be substantially the same (uniform). Note that the direction of rotation of the fourth roller 24 is not limited to the clockwise direction, and may be the counter-clockwise direction.

Further, in this embodiment, a temperature control mechanism such as a temperature control medium circulation system is provided inside the fourth roller 24. With this temperature control mechanism, control is performed as appropriate such that, for example, the temperature of the roller surface 24r can be equal to or higher than the melting point of lithium. Further, if the doctor blade 22 is provided near the roller surface 23r of the third roller 23, the thickness of the lithium 25 on the roller surface 23r is more accurately adjusted due to the provision of the doctor blade 22.

Also in the roll-to-roll deposition apparatus 2, the same actions and effects as the roll-to-roll deposition apparatus 1 can be provided. In particular, since the one roller (fourth roller 24) through which the lithium 25 passes is added, heat damage can be more reliably prevented in accordance with this embodiment.

### [Alternative Embodiment]

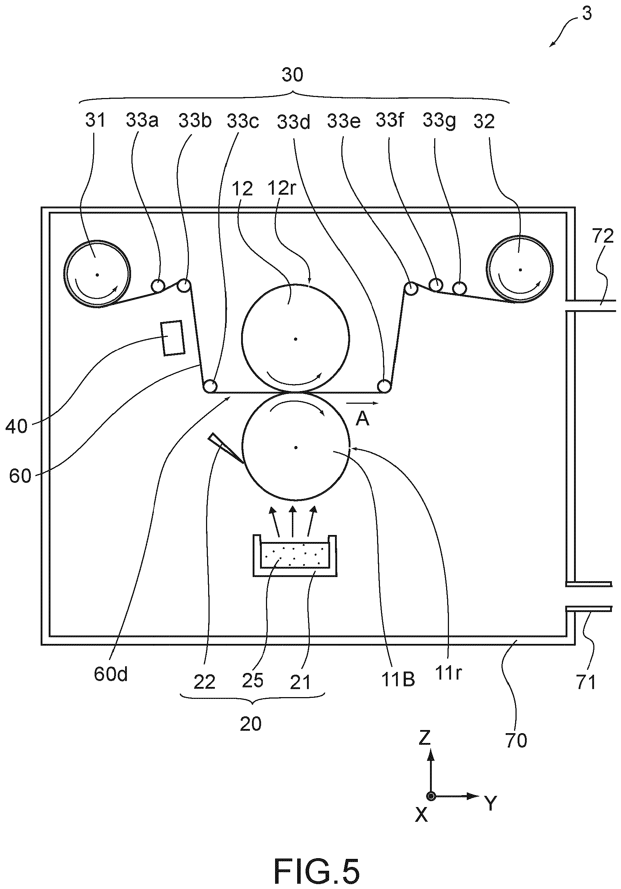

Fig. 5 is a schematic structural diagram of a roll-to-roll deposition apparatus according to an alternative embodiment.

A roll-to-roll deposition apparatus 3 shown in Fig. 5 includes a first roller 11B, the lithium source 20, the film travel mechanism 30, and the vacuum chamber 70. In addition, the roll-to-roll deposition apparatus 3 includes the second roller 12, the pretreatment mechanism 40, a protection layer-forming mechanism 50, the gas discharge mechanism 71, and the gas supply mechanism 72.

The first roller 11B is a tubular member containing metal such as stainless steel, iron, and aluminum. The first roller 11B is disposed between the film 60 and the lithium source 20. A roller surface 11r of the first roller 11B faces the deposition surface 60d of the film 60. For example, the roller surface 11r is held in contact with the deposition surface 60d of the film 60.

In addition, in the example of Fig. 5, the vapor deposition container 21 is disposed below the first roller 11B and vapor of the vapor deposition substance is caused to adhere to the first roller 11B that the vapor deposition container 21 faces. That is, the vapor deposition container 21 is disposed such that the evaporated lithium 25 adheres to a part of the roller surface 11r of the first roller 11B.

The transfer pattern is formed on the roller surface 11r. The transfer pattern is, for example, a concave pattern such as a groove-shaped pattern and a hole-shaped pattern. Therefore, the first roller 11B can also be called plate cylinder in intaglio.

The first roller 11B is rotatable about its center axis. For example, a rotary drive mechanism that rotationally drives the first roller 11B is provided outside the roll-to-roll deposition apparatus 3. Alternatively, the first roller 11B itself may include the rotary drive mechanism. For example, with the film 60 traveling in the arrow-A direction, the first roller 11B made to face the film 60 is rotated in the clockwise direction. At this time, the movement velocity of the roller surface 11r is set to be equal to the travel velocity of the film 60, for example. With this, after a lithium pattern is formed on the roller surface 11r, this lithium pattern is transferred to the deposition surface 60d of the film 60 without position shift.

Further, in this embodiment, a distance control mechanism that changes a relative distance between the first roller 11B and the vapor deposition container 21 may be provided outside the roll-to-roll deposition apparatus 3. Further, in this embodiment, a temperature control mechanism such as a temperature control medium circulation system is provided inside the first roller 11B. With this temperature control mechanism, the temperature of the roller surface 11r is controlled as appropriate.

When the first roller 11B is rotated with the lithium 25 vapor-deposited on the first roller 11B, the lithium 25 in the vapor deposition container 21 is upwardly moved via the roller surface 11r. With this, the lithium 25 evaporated from the vapor deposition container 21 is supplied to the entire area of the roller surface 11r of the first roller 11B.

Further, in the roll-to-roll deposition apparatus 3, the doctor blade 22 is provided near the roller surface 11r of the first roller 11B. Due to the provision of the doctor blade 22, the thickness of the lithium 25 in the transfer pattern is accurately adjusted. For example, the thickness of the lithium 25 in the transfer pattern is adjusted to be substantially the same (uniform).

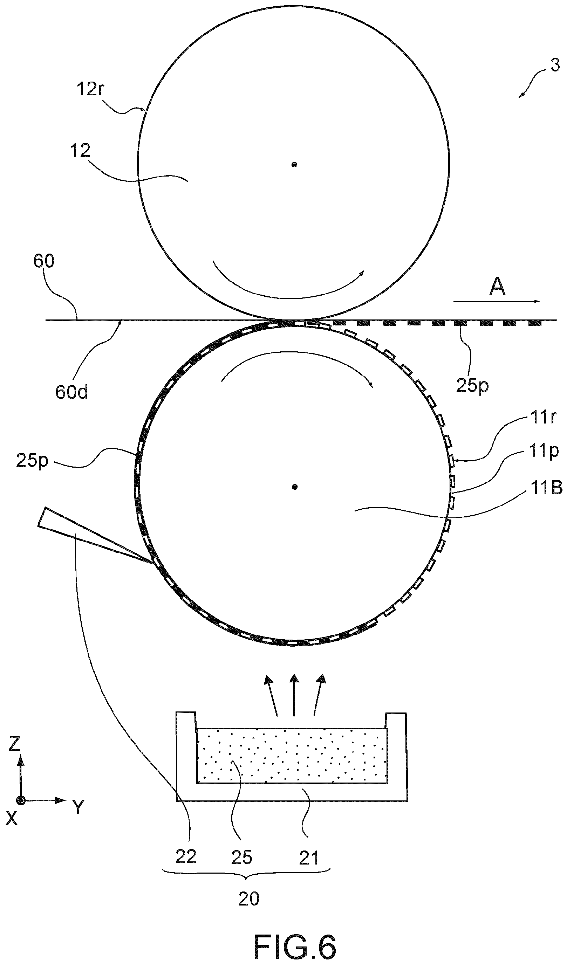

Fig. 6 is a schematic structural diagram showing an operation of the roll-to-roll deposition apparatus according to the alternative embodiment.

As shown in Fig. 6, a concave transfer pattern 11p is formed on the roller surface 11r of the first roller 11B. Further, the deposition surface 60d of the film 60 is subjected to pretreatment by the pretreatment mechanism 40.

Next, the evaporated lithium 25 is supplied to the transfer pattern 11p of the first roller 11B from the lithium source 20. For example, the vapor deposition container 21 is disposed below the first roller 11B such that the lithium 25 evaporated from the vapor deposition container 21 adheres to a part of the roller surface 11r of the first roller 11B. In addition, the temperature of the roller surface 11r of the first roller 11B is adjusted to the lithium melting point or more by the temperature control mechanism.

With this, the lithium 25 vapor-deposited on the first roller 11B is kept wet with the lithium 25 molten on the roller surface 11r. Further, the thickness of the lithium 25 on the roller surface 11r is accurately adjusted by the doctor blade 22.

The film 60 is traveling between the first roller 11B and the second roller 12 with the rotation of the first roller 11B and the second roller 12. Here, the first roller 11B is held in contact with the deposition surface 60d of the film 60. With this, the pattern 25p is also held in contact with the deposition surface 60d of the film 60, and the pattern 25p is transferred from the transfer pattern 11p to the deposition surface 60d of the film 60.

After that, the pattern 25p of the lithium 25 on the deposition surface 60d is naturally cooled, and the pattern 25p of the lithium layer is formed on the deposition surface 60d of the film 60. After that, a protection layer is further formed on the deposition surface 60d by the protection layer-forming mechanism 50 to cover the pattern 25p of the lithium layer.

Also in the roll-to-roll deposition apparatus 3, the same actions and effects as the roll-to-roll deposition apparatus 1 can be provided. In addition, in the roll-to-roll deposition apparatus 3, the transfer pattern 11p formed on the first roller 11B is the concave pattern, and hence the molten lithium 25 is efficiently received in the concave pattern. With this, the pattern 25p of the lithium layer formed on the deposition surface 60d of the film 60 becomes clearer.

### [Alternative Embodiment]

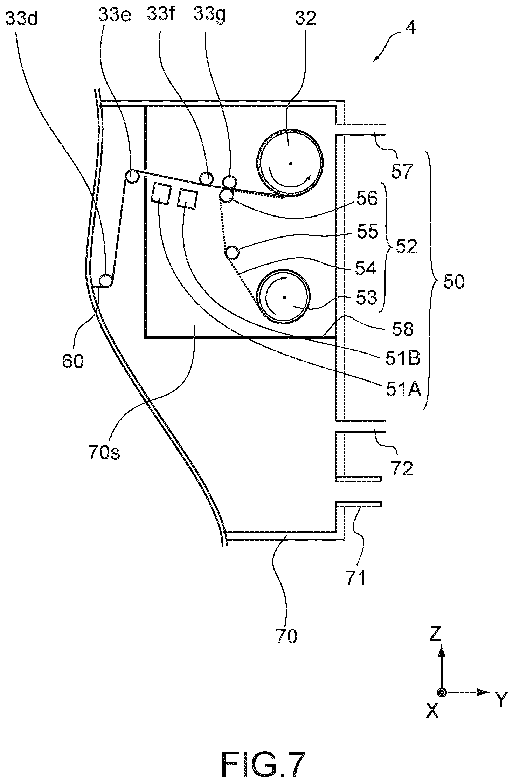

Fig. 7 is a schematic structural diagram of a part of a roll-to-roll deposition apparatus according to another alternative embodiment. Fig. 7 shows the take-up roller 32 and surroundings thereof.

A roll-to-roll deposition apparatus 4 shown in Fig. 7 further includes the protection layer-forming mechanism 50 that forms a protection layer or a protection film on the deposition surface 60d of the film 60 on which the pattern 25p of the lithium layer is formed. The protection layer-forming mechanism 50 can be combined with any of the above-mentioned roll-to-roll deposition apparatuses 1 to 3. The protection layer includes at least any of, for example, silicon oxide (SiOₓ), silicon nitride (SiNₓ), alumina oxide (AlOₓ), and the like.

The protection layer-forming mechanism 50 is placed downstream from the first roller 11A. The protection layer-forming mechanism 50 is capable of forming the protection layer or the protection film on the surface of the lithium layer after the lithium layer is formed on the film 60 by the first roller 11A.

The protection layer-forming mechanism 50 includes a protection layer-forming portion 51A, a protection layer-forming portion 51B, a protection film-forming portion 52, a gas supply mechanism 57, and a separator 58. The protection film-forming portion 52 includes a payout roller 53, a protection film 54, and guide rollers 55, 56. Each of the protection layer-forming portion 51A, the protection layer-forming portion 51B, and the protection film-forming portion 52 can be independently driven, and at least one of the protection layer-forming portion 51A, the protection layer-forming portion 51B, and the protection film-forming portion 52 can be driven.

Further, the separator 58 isolates the protection layer-forming mechanism 50 inside the vacuum chamber 70. In the example of Fig. 7, the separator 58 isolates the protection layer-forming portion 51A, the protection layer-forming portion 51B, the protection film-forming portion 52, and the gas supply mechanism 57. With this, the protection layer-forming mechanism 50 is isolated by the separator 58, and ingredients of the protection layer are barely mixed into the lithium layer.

The protection layer-forming portion 51A is capable of forming the protection layer on the deposition surface 60d of the film 60 by, for example, a film deposition technique such as sputtering, CVD (Chemical Vapor Deposition), vapor deposition. Further, by inputting elements such as silicon and aluminum from a deposition source of the protection layer-forming portion 51A into the deposition surface 60d of the film 60 while introducing gas such as oxygen, nitrogen, water, carbon monoxide, and carbon dioxide into a space 70s isolated from the gas supply mechanism 57 by the separator 58, a reaction product (protection layer) may be formed on the deposition surface 60d.

The protection layer-forming portion 51B is capable of forming the protection layer on the deposition surface 60d of the film 60 by, for example, plasma treatment or heat treatment. The protection layer may be formed on the surface of the lithium layer by, for example, introducing gas such as oxygen, nitrogen, water, carbon monoxide, and carbon dioxide into the space 70s isolated from the gas supply mechanism 57 by the separator 58 such that at least one of these gases reacts with the surface of the lithium layer. Further, in order to improve the reactivity of these gases, these gases may be transformed into plasma gases by a plasma generation means (not shown) added to the roll-to-roll deposition apparatus 4. Lithium oxide (Li₂O), lithium nitride (Li₃N), lithium carbonate (LiCOₓ), and the like are, for example, formed on the surface of the lithium layer by the protection layer-forming portion 51B.

Note that the roll-to-roll deposition apparatus 4 may include a gas discharge mechanism for discharging the gas inside the space 70s to prevent the gas inside the space 70s from leaking out of the space 70s. In this case, the pressure inside the space 70s is controlled to be lower than the pressure outside the space 70s. With this, for example, oxidation or the like of molten lithium stored in the vapor deposition container 21 is suppressed.

Further, the protection film-forming portion 52 is capable of bonding the protection film 54 to the deposition surface 60d of the film 60. For example, the protection film 54 is disposed facing the deposition surface 60d of the film 60. In addition, the protection film 54 is placed, nipped between the guide roller 33g and the guide roller 56.

The protection film 54 is wound around the payout roller 53 in advance and paid out from the payout roller 53. Supported by the guide roller 55, the protection film 54 paid out from the payout roller 53 is moved between the guide roller 33g and the guide roller 56. Then, the protection film 54 covers the deposition surface 60d of the film 60, and the protection film 54 is continuously taken up by the take-up roller 32 together with the film 60.

Hereinabove, the embodiments of the present invention have been described, though the present invention is not limited only to those embodiments. Various modifications can be made as a matter of course. For example, in the roll-to-roll deposition apparatus 1 to 3, the lithium source 20 may be a mechanism that supplies the lithium 25 evaporated from the vapor deposition container 21 to the first roller 11B, the third roller 23, or the fourth roller 24 via a nozzle, a shower, or the like.

The number of rollers provided between the film 60 and the vapor deposition container 21 is not limited thereto (1 to 3). Alternatively, four rollers may be provided between the film 60 and the vapor deposition container 21 in a manner that depends on purposes. Further, either one of the pretreatment mechanism 40 or the protection layer forming mechanism 50 or both the pretreatment mechanism 40 and the protection layer forming mechanism 50 may be selected.

Further, the vapor deposition rate (amount of vapor) can be controlled using the heating temperature of the lithium 25. Therefore, the doctor blade 22 may be omitted.

In addition, with the configuration in the first embodiment, the lithium 25 vapor-deposited on the third roller 23 is supplied to the first roller 11A with the lithium 25 molten on the roller surface, for example. Alternatively, a lithium film in the solid phase may be formed on the surface of the third roller and then the lithium film may be transferred to the deposition surface of the film via the surface of the first roller. In this case, a method of setting the adhesiveness of the surface of the third roller with the lithium film to be lower than the surface of the first roller and setting the adhesiveness of the surface of the first roller with the lithium film to be lower than the film deposition surface, for example, can be employed. In this case, the temperature of the surfaces of the first roller and the third roller are controlled to be a temperature lower than the melting point of the lithium by the temperature control mechanism.

### Reference Signs List

- 1, 2, 3, 4: roll-to-roll deposition apparatus
- 11A, 11B: first roller
- 11r: roller surface
- 11p: transfer pattern
- 12: second roller
- 12r: roller surface
- 20: lithium source
- 21: vapor deposition container
- 22: doctor blade
- 23: third roller
- 23r: roller surface
- 24: fourth roller
- 24r: roller surface
- 25: lithium
- 25p: pattern
- 30: film travel mechanism
- 31: payout roller
- 32: take-up roller
- 33a, 33b, 33c, 33d, 33e, 33f, 33g: guide roller
- 40: pretreatment mechanism
- 50: protection layer-forming mechanism
- 51A: protection layer-forming portion
- 51B: protection layer-forming portion
- 52: protection film-forming portion
- 53: payout roller
- 54: protection film
- 55, 56: guide roller
- 57: gas supply mechanism
- 58: separator
- 60: film
- 60d: deposition surface
- 70: vacuum chamber
- 70s: space
- 71: gas discharge mechanism
- 72: gas supply mechanism

## Claims

1. A roll-to-roll deposition apparatus, comprising:
a vacuum chamber (70) capable of maintaining a reduced-pressure state;
a film travel mechanism (30) capable of causing a film (60) to travel inside the vacuum chamber;
a lithium source (20) capable of evaporating lithium inside the vacuum chamber;
a first roller (11A) that is disposed between a deposition surface of the film and the lithium source, has a transfer pattern (11p) that receives the lithium evaporated from the lithium source (20), and transfers a pattern of a lithium layer corresponding to the transfer pattern to the deposition surface while rotating; and
a second roller (12) that faces the first roller (11A) with the film (60) provided between the second roller (12) and the first roller (11A), wherein
the lithium source includes
a vapor deposition container (21) that stores the lithium, and
a third roller (23) that faces the first roller (11A) and is disposed such that the lithium is vapor-deposited on the first roller ((11A) and that the lithium (25) evaporated from the vapor deposition container (21) adheres to a part of a roller surface (23r) of the third roller (23), and
a temperature control mechanism that adjusts a temperature of the roller surface (23r) of the third roller (23) to a lithium melting point or more such that the lithium (25) vapor-deposited on the third roller (23) is supplied to the first roller (11A) with the lithium molten on the roller surface (23r).

2. The roll-to-roll deposition apparatus according to claim 1, wherein
the lithium source further includes
a doctor blade (22) that controls a thickness of the lithium supplied from the vapor deposition container (21) to the third roller (23).

3. The roll-to-roll deposition apparatus according to claim 1 or 2, wherein
the lithium source further includes
a fourth roller (24) that faces the third roller, wherein
the vapor deposition container (21) that is disposed such that the lithium is deposited on the fourth roller (24).

4. The roll-to-roll deposition apparatus according to any one of claims 1 to 3, further comprising
a pretreatment mechanism (40) that cleans the deposition surface of the film, the pretreatment mechanism being placed upstream from the first roller (11A) .

5. The roll-to-roll deposition apparatus according to any one of claims 1 to 4, further comprising
a protection layer-forming mechanism (50) that forms a protection layer on a surface of the lithium layer, the protection layer-forming mechanism (50) being placed downstream from the first roller (11A).

6. The roll-to-roll deposition apparatus according to claim 5, further comprising
a separator (58) by which the protection layer-forming mechanism (50) is isolated inside the vacuum chamber (70).

7. A roll-to-roll deposition method, comprising:
causing a film (60) to travel between a first roller (11A) and a second roller (12) inside a vacuum chamber (70) capable of maintaining a reduced-pressure state;
supplying evaporated lithium from a vapor deposition container (21) to a third roller (23), the vapor deposition container (21) being disposed inside the vacuum chamber (70) and storing the lithium;
maintaining the lithium adhering to the third roller (23) in a melting state by a temperature control mechanism (50) of the third roller (23);
supplying the lithium in the melting state on the third roller (23) to the first roller (11A) on which a transfer pattern (11p) is formed; and
holding a pattern of a lithium layer corresponding to the transfer pattern (11p) in contact with a deposition surface (60d) of the film (60) to transfer the pattern of the lithium layer to the deposition surface (60d) while rotating the first roller (11A).

## Patentansprüche

1. Rolle-zu-Rolle-Beschichtungsvorrichtung, umfassend
eine Vakuumkammer (70), die in der Lage ist, einen Zustand reduzierten Drucks aufrechtzuerhalten;
einen Filmtransportmechanismus (30), der in der Lage ist, einen Film (60) zu veranlassen, sich innerhalb der Vakuumkammer zu bewegen; eine Lithiumquelle (20), die in der Lage ist, Lithium innerhalb der Vakuumkammer zu verdampfen; eine erste Walze (11A), die zwischen einer Abscheidungsoberfläche des Films und der Lithiumquelle angeordnet ist, ein Übertragungsmuster (11p) aufweist, das das von der Lithiumquelle (20) verdampfte Lithium aufnimmt und ein Muster einer Lithiumschicht entsprechend dem Übertragungsmuster auf die Abscheidungsoberfläche überträgt, während sie sich dreht; und
eine zweite Walze (12), die der ersten Walze (11A) gegenüberliegt, wobei der Film (60) zwischen der zweiten Walze (12) und der ersten Walze (11A) vorgesehen ist, wobei
die Lithiumquelle umfasst
einen Aufdampfungsbehälter (21), der das Lithium speichert, und
eine dritte Walze (23), die der ersten Walze (11A) zugewandt und so angeordnet ist, dass das Lithium auf die erste Walze (11A) aufgedampft wird und dass das aus dem Aufdampfbehälter (21) verdampfte Lithium (25) an einem Teil einer Walzenoberfläche (23r) der dritten Walze (23) haftet, und
einen Temperaturregelmechanismus, der eine Temperatur der Walzenoberfläche (23r) der dritten Walze (23) auf einen Lithiumschmelzpunkt oder mehr einstellt, so dass das auf der dritten Walze (23) aufgedampfte Lithium (25) der ersten Walze (11A) zugeführt wird, wobei das Lithium auf der Walzenoberfläche (23r) geschmolzen ist.

2. Rolle-zu-Rolle-Beschichtungsvorrichtung nach Anspruch 1, wobei die Lithiumquelle ferner umfasst
eine Rakel (22), die die Dicke des aus dem Aufdampfbehälter (21) der dritten Walze (23) zugeführten Lithiums steuert.

3. Rolle-zu-Rolle-Beschichtungsvorrichtung nach Anspruch 1 oder 2, wobei die Lithiumquelle ferner umfasst
eine vierte Walze (24), die der dritten Walze gegenüberliegt, wobei der Aufdampfbehälter (21) so angeordnet ist, dass das Lithium auf der vierten Walze (24) abgeschieden wird.

4. Rolle-zu-Rolle-Beschichtungsvorrichtung nach einem der Ansprüche 1 bis 3, die ferner umfasst
einen Vorbehandlungsmechanismus (40), der die Abscheidungsoberfläche des Films reinigt, wobei der Vorbehandlungsmechanismus stromaufwärts von der ersten Walze (11A) angeordnet ist.

5. Rolle-zu-Rolle-Beschichtungsvorrichtung nach einem der Ansprüche 1 bis 4, die ferner umfasst
einen eine Schutzschicht bildenden Mechanismus (50), der eine Schutzschicht auf einer Oberfläche der Lithiumschicht bildet, wobei der eine Schutzschicht bildende Mechanismus (50) stromabwärts von der ersten Walze (11A) angeordnet ist.

6. Rolle-zu-Rolle-Beschichtungsvorrichtung nach Anspruch 5, ferner umfassend einen Separator (58), durch den der Schutzschichtbildungsmechanismus (50) innerhalb der Vakuumkammer (70) isoliert ist.

7. Rolle-zu-Rolle-Beschichtungsverfahren, umfassend:
Veranlassen, dass ein Film (60) zwischen einer ersten Walze (11A) und einer zweiten Walze (12) innerhalb einer Vakuumkammer (70) bewegt, die in der Lage ist, einen reduzierten Druck aufrechtzuerhalten, läuft;
Zuführen von verdampftem Lithium aus einem Aufdampfungsbehälter (21) zu einer dritten Walze (23), wobei der Aufdampfungsbehälter (21) innerhalb der Vakuumkammer (70) angeordnet ist und das Lithium speichert;
Halten des an der dritten Walze (23) haftenden Lithiums in einem Schmelzzustand durch einen Temperaturregelmechanismus (50) der dritten Walze (23);
Zuführen des Lithiums in dem Schmelzzustand auf der dritten Walze (23) zu der ersten Walze (11A), auf der ein Übertragungsmuster (11p) gebildet wird; und
Halten eines Musters einer Lithiumschicht, das dem Übertragungsmuster (11p) entspricht, in Kontakt mit einer Ablagerungsoberfläche (60d) des Films (60), um das Muster der Lithiumschicht auf die Ablagerungsoberfläche (60d) zu übertragen, während die erste Walze (11A) rotiert.

## Revendications

1. Appareil de dépôt de rouleau à rouleau, comprenant :
une chambre à vide (70) capable de maintenir un état de pression réduite;
un mécanisme de déplacement de film (30) capable de faire voyager un film (60) à l'intérieur de la chambre à vide ; une source de lithium (20) capable d'évaporer le lithium à l'intérieur de la chambre à vide ; un premier rouleau (11A) qui est disposé entre une surface de dépôt du film et la source de lithium, a un motif de transfert (11p) qui reçoit le lithium évaporé de la source de lithium (20), et transfère un motif d'une couche de lithium correspondant au motif de transfert à la surface de dépôt tout en tournant ; et
un second rouleau (12) qui fait face au premier rouleau (11A) avec le film (60) placé entre le second rouleau (12) et le premier rouleau (11A), dans lequel
la source de lithium comprend
un conteneur de dépôt en phase vapeur (21) qui stocke le lithium, et
un troisième rouleau (23) qui fait face au premier rouleau (11A) et qui est disposé de manière à ce que le lithium soit déposé à la vapeur sur le premier rouleau ((11A) et que le lithium (25) évaporé du récipient de dépôt à la vapeur (21) adhère à une partie de la surface du rouleau (23r) du troisième rouleau (23), et
un mécanisme de contrôle de la température qui ajuste la température de la surface (23r) du troisième rouleau (23) à un point de fusion du lithium ou plus, de sorte que le lithium (25) déposé à la vapeur sur le troisième rouleau (23) est fourni au premier rouleau (11A) avec le lithium fondu sur la surface du rouleau (23r).

2. L'appareil de dépôt de rouleau à rouleau selon la revendication 1, dans lequel la source de lithium comprend en outre
une racle (22) qui contrôle l'épaisseur du lithium fourni par le conteneur de dépôt en phase vapeur (21) au troisième rouleau (23).

3. L'appareil de dépôt rouleau à rouleau selon la revendication 1 ou 2, dans lequel la source de lithium comprend en outre
un quatrième rouleau (24) qui fait face au troisième rouleau, dans lequel le récipient de dépôt de vapeur (21) est disposé de manière à ce que le lithium soit déposé sur le quatrième rouleau (24).

4. L'appareil de dépôt rouleau à rouleau selon l'une des revendications 1 à 3, comprenant en outre
un mécanisme de prétraitement (40) qui nettoie la surface de dépôt du film, le mécanisme de prétraitement étant placé en amont du premier rouleau (11A).

5. L'appareil de dépôt rouleau à rouleau selon l'une quelconque des revendications 1 à 4, comprenant en outre
un mécanisme de formation de couche de protection (50) qui forme une couche de protection sur une surface de la couche de lithium, le mécanisme de formation de couche de protection (50) étant placé en aval du premier rouleau (11A).

6. L'appareil de dépôt rouleau à rouleau selon la revendication 5, comprenant en outre un séparateur (58) par lequel le mécanisme de formation de la couche de protection (50) est isolé à l'intérieur de la chambre à vide (70).

7. Méthode de dépôt de rouleau à rouleau, comprenant :
faire voyager un film (60) entre un premier rouleau (11A) et un second rouleau (12) à l'intérieur d'une chambre à vide (70) capable de maintenir une pression réduite;
fournir du lithium évaporé à partir d'un conteneur de dépôt de vapeur (21) à un troisième rouleau (23), le conteneur de dépôt de vapeur (21) étant disposé à l'intérieur de la chambre à vide (70) et stockant le lithium;
maintenir le lithium adhérant au troisième rouleau (23) dans un état de fusion par un mécanisme de contrôle de la température (50) du troisième rouleau (23);
fournir le lithium à l'état de fusion sur le troisième rouleau (23) au premier rouleau (11A) sur lequel un motif de transfert (11p) est formé ; et
maintenir un motif d'une couche de lithium correspondant au motif de transfert (11p) en contact avec une surface de dépôt (60d) du film (60) pour transférer le motif de la couche de lithium à la surface de dépôt (60d) tout en faisant tourner le premier rouleau (11A).
